# EUROPEAN PATENT APPLICATION

(11) **EP 1 761 115 A2**
(43) Date of publication of application: **07.03.2007**
(21) Application number: 06018262.3
(22) Date of filing: 31.08.2006
(51) Int. Cl.: H05K 1/11

(54) **Printed wiring board and method for fabricating the same**

(30) Priority: 31.08.2005 JP 2005250815
(71) Applicant: SHINKO ELECTRIC INDUSTRIES CO., LTD., Nagano-shi, Nagano 381-2287 (JP)
(72) Inventor: Arai, Koji Shinko Electric Industries Co. Ltd., Nagano 381-2287 (JP); Kikuchi, Tomofumi Shinko Electric Ind. Co. Ltd, Nagano 381-2287 (JP); Maruyama, Atsushi Shinko Electric Ind. Co. Ltd., Nagano 381-2287 (JP); Wakabayashi, Hideyuki Shinko Electric Ind. Co. Ltd, Nagano 381-2287 (JP)
(74) Representative: Zimmermann & Partner

(57) **Abstract**

The invention is characterized in a printed wiring board having a wiring pattern 14 including a pad for mounting a solder ball as a connection terminal, wherein
the pad 20 is constituted by laminating a conductive layer constituting the wiring pattern, a lower layer plating layer, and an upper layer plating layer in this order;
an immediate vicinity region 34 surrounding the pad is constituted by laminating the conductive layer, at least the lower layer plating layer in the lower layer plating layer and the higher layer plating layer, and a solder resist layer in the order;
a thickness of the upper layer plating layer is a thickness negligible in comparison with respective thicknesses of the lower layer plating layer and the upper layer plating layer; and
a height of an upper face of the pad does not exceed a height of an upper face of the immediate vicinity region.

## Description

The present invention generally relates to a printed wiring board having a wiring pattern. More particular, it relates to a printed wiring board having a wiring pattern including a pad for mounting a solder ball as a connection terminal and its fabricating method.

Generally, according to a wiring pattern of a wiring board used for a semiconductor package, a predetermined portion thereof is formed as a pad for mounting a solder ball as a connection terminal. According to the pad for mounting the solder ball, a surface of a conductive layer of Cu or the like constituting the wiring pattern is generally subjected to plating of Ni/Au plating or the like in order to promote a solder bonding property.

Fig. 1A shows a sectional structure of a vicinity of a pad for mounting a solder ball of a printed wiring board of a conventional art. An illustrated printed wiring board 10 is formed with a wiring pattern 14 including a conductive layer of Cu or the like on an insulating board 12 of resin or the like. The wiring pattern 14 includes a portion 14A for a pad for mounting a solder ball and an immediate vicinity wiring 14B separated therefrom.

A pad 20 for mounting a solder ball is formed by coating an Ni plating layer 16 as a lower layer plating layer and an Au plating layer 18 as an upper layer plating layer in this order on a surface of the portion 14A for the pad of the wiring pattern 14. This is shown in the drawing as '20:14A+16+18' as a supplementary note.

An immediate vicinity region 24 separated from the pad 20 is formed by the immediate vicinity wiring 14B separated from the portion 14A for the pad of the wiring pattern 14, and a solder resist layer 22 for covering the immediate vicinity wiring 14B. This is shown in the drawing as '24:14B+22' as a supplementary note.

In the layer structure, the respective layers are formed by being accompanied by variations within respective allowable tolerances. As a result, a high or low relationship between an upper face P (upper face of Au plating layer 18) of the pad 20 and an upper face Q (upper face of solder resist layer 22) of the immediate vicinity region 24 is not constant. Particularly, a problem is posed when the upper face P of the pad 20 becomes higher than the upper face Q of the immediate vicinity region 24 as shown by Fig.1A.

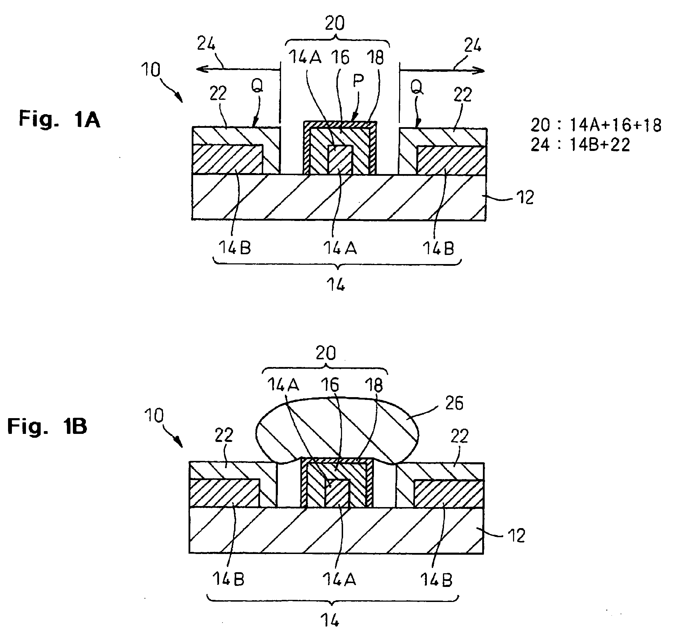

That is, as shown by Fig.1B, when a solder ball 26 is placed and melted to be mounted on the pad 20, a peripheral edge portion of the solder ball 26 mounted on the pad 20 is deformed to hang down to the low immediate vicinity region 24 and a predetermined shape is not provided.

Further, the pad 20 jumps out from the immediate vicinity region 24 and therefore, there is a danger of deteriorating the solder bonding property by destructing the Au plating layer 18 at a top portion of the pad 20 by being brought into contact with other of the printed wiring board 10 or a jig in handling.

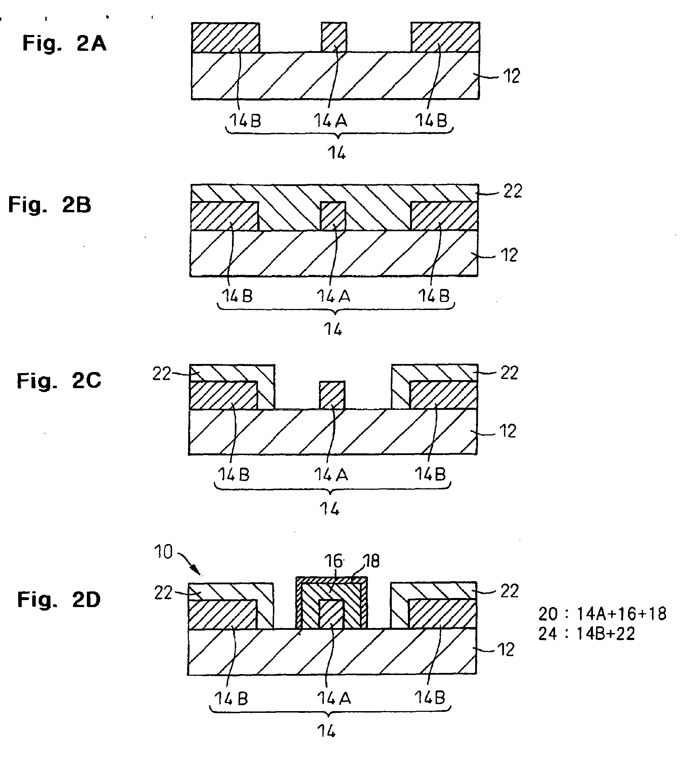

As explanation steps of fabricating the printed wiring board 10 of the conventional art of Fig. 1A in reference to Fig.2 will be given. Processing steps explained below constitute a general method disclosed in, for example, JP-A-2000-58563 or the like.

First, as shown by Fig. 2A, the wiring pattern 14 is formed on the insulating board 12 or the like by patterning a conductive layer of Cu or the like. This is carried out by a procedure of machining a through hole, electroless copper plating and electrolytic copper plating, laminating, exposing, developing a dry film, etching a copper conductive layer, and exfoliating the dry film by using a both faces copper coated laminated plate, as one typical example by a well-knownmethod. The wiring pattern 14 includes the portion 14A for the pad for mounting the solder ball and the immediate vicinity wiring 14B separated therefrom.

Next, as shown by Fig.2B, the solder resist layer 22 is formed over an entire face of the board 12 by screen printing.

Next, as shown by Fig.2C, the portion 14A for the pad of the wiring pattern 14 is exposed by patterning the solder resist layer 22 by exposure and development. The immediate vicinity wiring 14B separated therefrom is covered by the solder resist layer 22.

Finally, as shown by Fig.2D, electrolytic plating is carried out, and the Ni plating layer 16 as the lower layer plating layer and the Au plating layer 18 as the upper layer plating layer thereabove are formed over an entire face (total of upper face and side face) of the portion 14A for the pad of the wiring pattern 14 exposed as described above.

Thereby, there is finished the printed wiring board 10 including the solder ball mounting pad 20 (portion 14A for pad of the wiring pattern 14 + Ni plating layer 16 + Au plating layer 18) and the immediate vicinity region 24 (immediate vicinity wiring 14B + solder resist layer 22).

The high or low relationship between the pad 20 and the immediate vicinity region 24 provided is determined by a relationship between a thickness of the Ni plating layer 16 of the pad 20 and a thickness of the solder resist layer 22 of the immediate vicinity region 24 as a result thereof.

In consideration of contribution of other constituent portion with regard to the high or low relationship, first, the wiring pattern 14 (14A, 14B) is formed by the conductive layer common to the both portions (20, 22) and therefore, the wiring pattern 14 is excluded as a factor of a difference of heights. Also the Au plating layer 18 of the pad 20 is much thinner than other layers and therefore, contribution thereof to the height is negligible.

Generally, the Ni plating layer 16 is provided with an allowable tolerance of about ±5µm with regard to a thickness of 10µm, and the solder resist layer 22 is provided with an allowable tolerance of about ±10µm with regard to a thickness of 15µm. Therefore, the thickness of the Ni plating layer 16 constituting a factor of varying a height Hp of the upper face P of the pad 20 is varied in a range of 10±5µm=5µm through 15µm, and the thickness of the solder resist layer 22 constituting a factor of varying a height Hq of the upper face Q of the immediate vicinity region 24 is varied in a range of 15±10µm=5µm through 25µm.

Therefore, a high or low relationship between the pad upper face height Hp and the immediate vicinity region upper face height Hq is varied in a range of Hp-Hq= [thickness of Ni plating layer 16] - [thickness of solder resist layer 22] =-20µm through +10µm, and is varied in a range from a state in which the pad 20 is lower than the immediate vicinity region 24 by 20µm to a state in which the pad 20 is conversely higher than the immediate vicinity region 24 by 10µm. Further, the variation is brought about when the processing is carried out by controlling to form the Ni plating layer and form the solder resist layer within allowable tolerances and therefore, it is in fact impossible to stably control the high or low relationship of pad/immediate vicinity region in an actual processing process.

Although the conventional art structure and method are concerned with a pad mode posing the problem by the high or low relationship between the pad and the immediate vicinity region separated therefrom, there is also a pad posing a similar problem by a difference of heights of a pad and an immediate vicinity region brought into contact therewith.

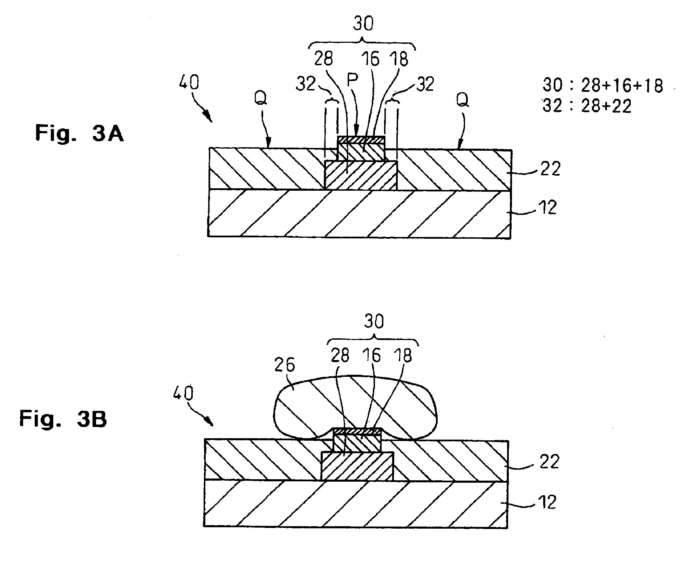

Fig.3A shows a sectional structure of a vicinity of a pad for mounting a solder ball of a printed wiring board of a conventional art. An illustrated printed wiring board 40 is formed with a wiring pattern 28 including a conductive layer of Cu or the like on the insulating board 12 of resin or the like. At an illustrated position, the wiring pattern 28 is a portion for forming a pad.

A peripheral edge portion of an upper face of the wiring pattern 28 is masked by the solder resist layer 22 and a pad 30 is constituted within an opening of a center portion rectified thereby by forming the Ni plating layer 16 as the lower layer plating layer and the Au plating layer 18 as the upper layer plating layer. The pad mode is a so-to-speak SMD type (Solder Mask Define Type), in contrast thereto, the above-described pad mode is an NMSD type (Non Solder Mask Define Type).

Also in the case of the SMD type, a problem similar to that of the NMSD type is posed.

That is, when the upper face P of the pad 30 becomes higher than the upper face Q of the solder resist layer 22 of an immediate vicinity region 32, a peripheral edge portion of the solder ball 26 mounted on the pad 30 is deformed to hang down to a height of the low immediate vicinity region 32 and the predetermined shape is not provided.

Further, the pad 30 jumps out from the immediate vicinity region 32 and therefore, there is a danger of deteriorating the soldering bonding property by destructing the Au plating layer 18 of the top portion of the pad 30 by being brought into contact with other of the printed wiring board 40 or a jig in handling thereof.

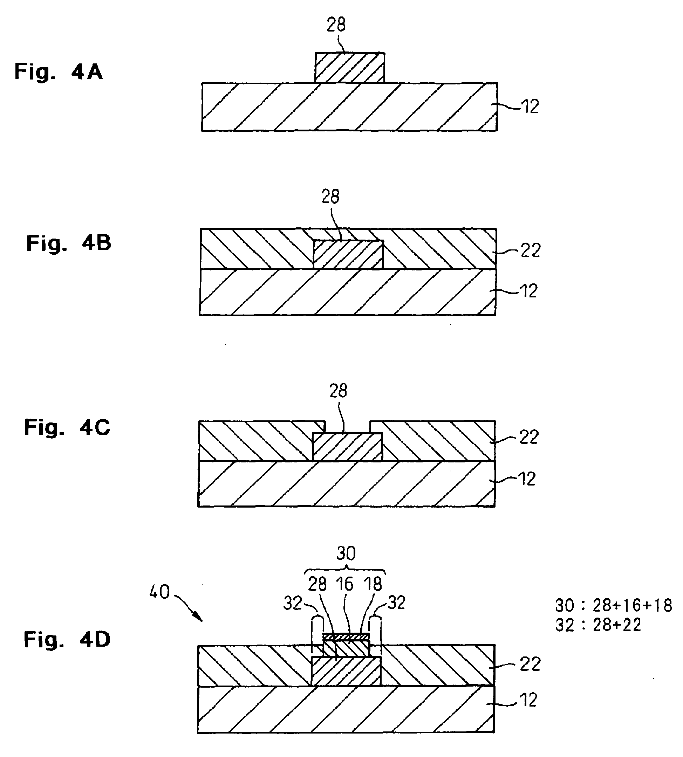

An explanation will be given of steps of fabricating the printed wiring board 40 of the conventional art of the SMD type of Fig.3A in reference to Fig.4. Also the processing steps constitute a well-known general method.

First, as shown by Fig. 4A, the wiring pattern 28 is formed on the insulating board 12 of resin or the like by patterning a conductive layer of Cu or the like. This is carried out by a procedure of machining a through hole, electroless copper plating and electrolytic copper plating, laminating, exposing, developing a dry film, etching a copper conductive layer, exfoliating the dry film by using a both faces copper coated laminated plate as a typical example by a well-known method. The wiring pattern 28 is a portion for a pad for mounting a solder ball.

Next, as shown by Fig.4B, the solder resist layer 22 is formed over an entire face of the board 12 by screen printing.

Next, as shown by Fig.4C, the solder resist layer 22 is patterned by exposure and development to expose only a center portion of an upper face of the wiring pattern 28. Other portion of the wiring pattern 28 is covered by the solder resist layer 22.

Finally, as shown by Fig.4D, electrolytic plating is carried out, and the Ni plating layer 16 as the lower layer plating layer and the Au plating layer 18 as the upper layer plating layer thereabove are formed at a center portion of the upper face of the wiring pattern 28 exposed as described above.

Thereby, there is finished the printed wiring board 40 having the wiring pattern 28 including the pad 30 for mounting the solder ball (center portion of the wiring pattern 28 + Ni plating layer 16 + Au plating layer 18). The pad 30 and the immediate vicinity region 32 are brought into direct contact with each other.

The high or low relationship of the pad 30 and the immediate vicinity region 32 provided is determined by a relationship between the thickness of the Ni plating layer 16 of the pad 30 and the thickness of the solder resist layer 22 of the immediate vicinity region 32 as a result thereof.

In consideration of contribution of other constituent portion with regard to the high or low relationship, first, the wiring pattern 28 is common to the both portions and therefore, the wiring pattern 28 is excluded as a factor of a difference of heights thereof, also the Au plating layer 18 of the pad 30 is much thinner than other layer and therefore, contribution thereof to the height is negligible.

Also in the case of pad 30 of the SMD type, the high or low relationship is varied within a similar range by reason similar to the pad 20 of the NSMD type, even when the Ni plating layer and the solder resist layer are controlled within the allowable tolerances, it is in fact impossible to control the high or low relationship.

It is an object of the invention to provide a printed wiring board for preventing a mounted solder ball from being deformed and preventing a pad before being mounted from being destructed by controlling the pad for mounting the solder ball as a connection terminal provided at a wiring pattern from becoming higher than an immediate vicinity region.

In light of the above, the printed wiring board according to independent claim 1 and the method for fabricating a printed wiring board according to independent claim 5 are provided. Further advantages, features, aspects and details of the invention are evident from the dependent claims, the description and the drawings.
In order to achieve the above-described obj ect, there is provided a printed wiring board including:
a wiring pattern; and
a pad for mounting a solder ball as a connection terminal, wherein
the wiring pattern includes the pad;
the pad is constituted by laminating a conductive layer constituting the wiring pattern, a lower layer plating layer, and an upper layer plating layer in this order;
an immediate vicinity region surrounding the pad is constituted by laminating the conductive layer, at least the lower layer plating layer in the lower layer plating layer and the upper layer plating layer, and a solder resist layer in this order;
a thickness of the upper layer plating layer is a thickness negligible in comparison with respective thicknesses of the lower layer plating layer and the solder resist layer; and
a height of an upper face of the pad does not exceed a height of an upper face of the immediate vicinity region.

Typically, the conductive layer is made of Cu, the lower layer plating layer is made of Ni, and the upper layer plating layer is made of Au, respectively.

The immediate vicinity region may be formed with being separated from the pad, or may be formed with being brought into contact with the pad.

Further, according to the invention, there is provided a method for fabricating the printed wiring board, the method including the steps of:
forming the wiring pattern by patterning a conductive layer on an insulating board integral therewith;
forming the lower layer plating layer on the conductive layer constituting the wiring pattern;
forming the upper layer plating layer at least at a predetermined portion on the lower layer plating layer for forming the pad; and
forming the solder resist layer at other than the predetermined portion on the lower layer plating layer for forming the pad.

According to the invention, the pad is constituted by laminating the conductive layer for the wiring pattern, the lower layer plating layer and the upper layer plating layer, the immediate vicinity region surrounding the pad is constituted by laminating the conductive layer, the lower layer plating layer (and the upper layer plating layer) and the solder resist layer, the thickness of the upper layer plating layer is negligible and therefore, a difference of heights of the pad and the immediate vicinity region is determined only by a thickness of the solder resist layer and therefore, by controlling the thickness of the solder resist layer within an allowable tolerance, the height of the upper face of the pad can be controlled so as not to exceed the height of the upper face of the immediate vicinity region.

Further, an embodiment relates to a printed wiring board. The printed wiring board includes a wiring pattern, and a pad for mounting a solder ball as a connection terminal, wherein the wiring pattern includes the pad, the pad is constituted by laminating a conductive layer constituting the wiring pattern, a lower layer plating layer, and an upper layer plating layer in this order, an immediate vicinity region surrounding the pad is constituted by laminating the conductive layer, at least the lower layer plating layer in the lower layer plating layer and the upper layer plating layer, and a solder resist layer in this order, and a height of an upper face of the pad does not exceed a height of an upper face of the immediate vicinity region.

Embodiments described herein further relate to a printed wiring board having a wiring pattern including a pad for mounting a solder ball as a connection terminal, wherein the pad is constituted by laminating a conductive layer constituting the wiring pattern, a lower layer plating layer, and an upper layer plating layer in this order, an immediate vicinity region surrounding the pad is constituted by laminating the conductive layer, at least the lower layer plating layer in the lower layer plating layer and the higher layer plating layer, and a solder resist layer in the order, a thickness of the upper layer plating layer is a thickness negligible in comparison with respective thicknesses of the lower layer plating layer and the upper layer plating layer, and a height of an upper face of the pad does not exceed a height of an upper face of the immediate vicinity region.

Embodiments according to the invention are also directed to method steps that may be performed by way of hardware components, a computer programmed by appropriate software, by any combination of the two or in any other manner. Furthermore, embodiments according to the invention are also directed to methods by which the described apparatus is manufactured. It includes method steps for manufacturing every part of the apparatus.

The invention will be better understood by reference to the following description of embodiments of the invention taken in conjunction with the accompanying drawings, wherein:
Fig.1A is a sectional view of a printed wiring board (pad mode: NMSD type) of a conventional art and Fig.1B is a sectional view showing a state of mounting a solder ball thereon.
Figs.2A to 2D illustrate sectional views showing steps of fabricating the printed wiring board of the conventional art of Figs.1A and 1B.
Fig.3A is a sectional view of a printed wiring board (pad mode: SMD type) of the conventional art and Fig.3B is a sectional view showing a state of mounting a solder ball thereon.
Figs.4A to 4D illustrate sectional views showing steps of fabricating the printed wiring board of the conventional art of Figs.3A and 3B.
Fig.5A is a sectional view of a printed wiring board (pad mode: NMSD type) of the invention and Fig.5B is a sectional view showing a state of mounting a solder ball thereon.
Figs.6A to 6E illustrate sectional views showing steps of fabricating the printed wiring board of the invention of Fig. 5.
Fig.7 is a sectional view showing a modified mode of the printed wiring board of the invention of Fig.5.
Figs.8A to 8D illustrate sectional views showing steps of fabricating the printed wiring board of the invention of Fig.7.
Fig. 9 is a sectional view showing other modified mode of the printed wiring board of the invention of Fig.5.
Figs.10A to 10G illustrate sectional views showing steps of fabricating the printed wiring board of the invention of Fig.9.
Fig. 11A is a sectional view of a printed wiring board (pad mode: SMD type) of the invention and Fig.11B is a sectional view showing a state of mounting a solder ball thereon.
Figs. 12A to 12E illustrate sectional views showing steps of fabricating the printed wiring board of the invention of Fig.11.

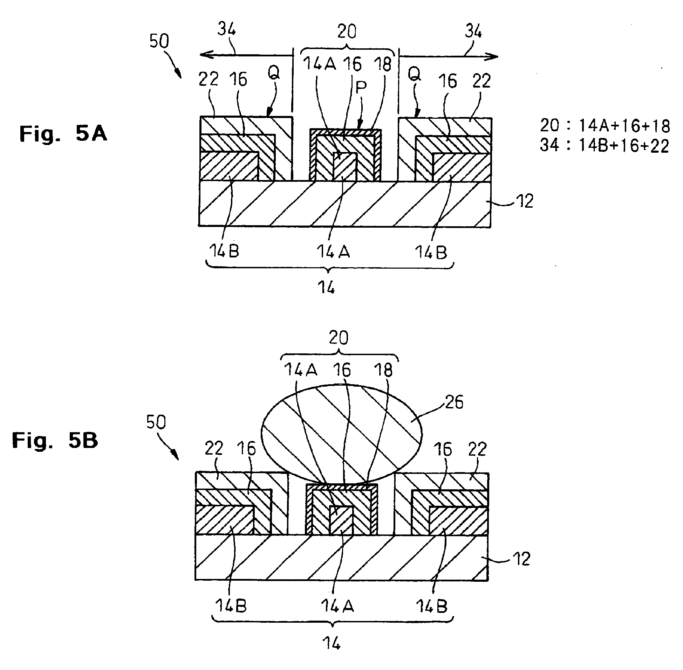

Fig.5 shows a printed wiring board including a pad of an NSMD type (Non Solder Mask Define Type) according to an embodiment of the invention.

As shown by Fig.5A, a printed wiring board 50 of the invention is formed with the wiring pattern 14 including the conductive layer of Cu or the like on the insulating board 12 of resin or the like. The wiring pattern 14 includes the portion 14A for a pad for mounting a solder ball and an immediate vicinity wiring 14B separated therefrom.

The pad 20 for mounting the solder ball is formed by coating the Ni plating layer 16 as an lower layer plating layer and the Au plating layer 18 as an upper layer plating layer in this order on the surface of the portion 14A for the pad of the wiring pattern 14. This is shown in the drawing as '20:14A+16+18' as a supplementary note.

An immediate vicinity region 34 separated from the pad 20 is formed by the immediate vicinity wiring 14B separated from the portion 14A for the pad of the wiring pattern 14, the Ni plating layer 16 as the lower layer plating layer for coating the immediate vicinity wiring 14B, and the solder resist layer 22 further coating the Ni plating layer 16. This is shown in the drawing as '34:14B+16+22' as a supplementary note.

In the layer structure, the respective layers are formed by being accompanied by variations within respective allowable tolerances, and a high or low relationship between the upper face P (upper face of the Au plating layer 18) of the pad 20 and the upper face Q (upper face of the solder resist layer 22) of the immediate vicinity region 34 is determined only by the thickness of the solder resist layer 22.

Therefore, a high or low relationship of pad low/immediate vicinity region high can always stably be maintained by controlling the height of the upper face P of the pad 20 so as not to exceeds the height of the upper face Q of the immediate vicinity region 34.

A specific explanation will be given of an example of a layer constitution the same as that explained in the conventional art.

That is, generally, the Ni plating layer 16 is provided with the allowable tolerance of about ±5µm with regard to the thickness of 10µm, and the solder resist layer 22 is provided with the allowable tolerance of about ±10µm with regard to the thickness of 15µm. However, according to the invention, the pad 20 and the immediate vicinity region 34 include the common Ni plating layer 16, the Ni plating is summarizingly carried out in the same plating processing step and therefore, the Ni plating layers 16 of the both portions are formed always by the common thickness and therefore, the allowable tolerance of the Ni plating layer 16 does not contribute to the high or low relationship of the both portions.

Therefore, the factor of varying the height Hq of the upper face Q of the immediate vicinity region 34 is constituted only by the thickness of the solder resist layer 22 and Hq is varied within the range of 15±10µm=5µm through 25µm.

The thickness of the Au plating layer 18 as the upper layer plating layer is generally less than 1µm (0.001 through less than 1µm) and is equal to or smaller than 1/10 or equal to 1/100 of the thickness of the solder resist layer and is negligible. As a result, the high or low relationship between the pad upper face height Hp and the immediate vicinity region upper face height Hq falls in a range of Hp-Hq=[thickness of Au plating layer 18 ≈ 0] - [thickness of the solder resist layer 22]=-5µm through -25µm, and the pad upper face height Hp is controlled always in a state of being lower than the immediate vicinity region upper face height Hq.

Therefore, when the solder ball 26 is placed and melted to be mounted on the pad 20, the peripheral edge portion of the solder ball 26 mounted on the pad 20 is held by the high immediate vicinity region 34, and the solder ball 26 can be mounted by an excellent shape.

Further, the pad 20 does not jump out from the immediate vicinity region 34 and therefore, the top portion of the pad 20 is not destructed by being brought into contact therewith in handling and an excellent solder bonding property can stably be maintained.

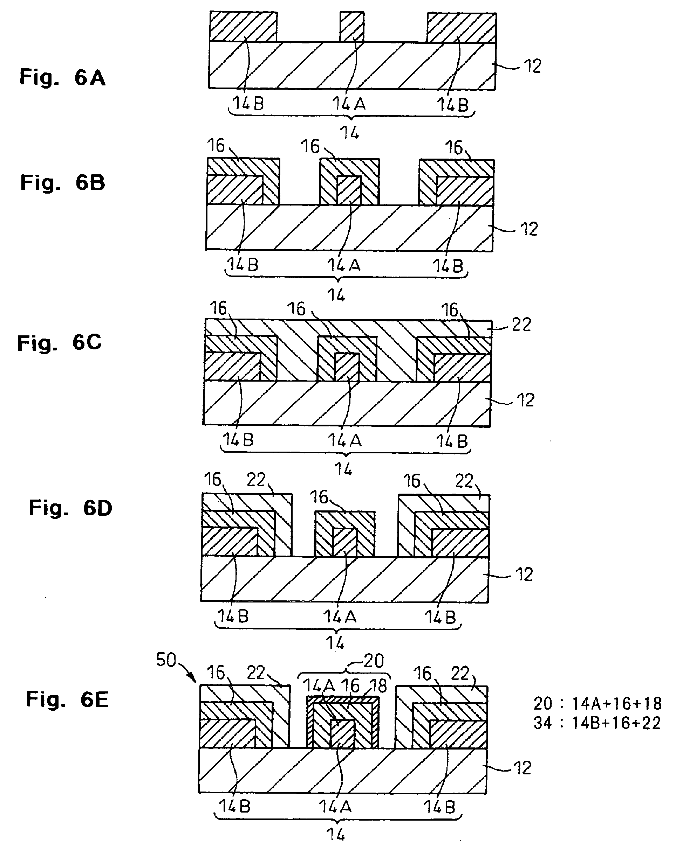

An explanation will be given of steps of fabricating the printed wiring board 50 according to the invention of Fig.5A in reference to Fig.6.

First, as shown by Fig. 6A, the wiring pattern 14 is formed by patterning the conductive layer of Cu or the like on the insulating board 12 of resin or the like. This is carried out by a procedure of machining a through hole, electroless copper plating and electrolytic copper plating, laminating, exposing, developing a dry film, etching a copper conductive layer, exfoliating the dry film by using a both faces copper coated laminated plate as one typical example by a well-known method. The wiring pattern 14 includes the portion 14A for the pad for mounting the solder ball and the immediate vicinity wiring 14B separated therefrom.

Next, as shown by Fig.6B, electrolytic Ni plating is carried out and the Ni plating layer 16 as the lower layer plating layer is formed at the wiring pattern 14 (14A, 14B).

Next, as shown by Fig.6C, the solder resist layer 22 is formed over an entire face of the board 12 by screen printing.

Next, as shown by Fig.6D, the Ni plating layer 16 formed on the portion 14A for the pad of the wiring pattern 14 is exposed by patterning the solder resist layer 22 by exposure and development. The immediate vicinity wiring 14B separated from the portion 14A for the pad is coated by the Ni plating layer 16 and the solder resist layer 22 thereabove.

Finally, as shown by Fig.6E, electrolytic Au plating is carried out and the Au plating layer 18 as the upper layer plating layer is formed over an entire face (total of upper face and side face) of the Ni plating layer 16 of the portion 14A for the pad of the wiring pattern 14 exposed as described above. Thereby, the printed wiring board 50 of Fig.5A is provided.

According to the invention, a structure by which the high or low relationship between the pad 20 and the immediate vicinity region 34 is not influenced by the thickness of the Ni plating layer 16 is provided by adopting the fabrication method of forming the Ni plating layer 16 on all of the wiring pattern 14 and thereafter forming the solder resist layer 22 as described above. Further, since the thickness of the Au plating layer 18 is negligible relative to that of the solder resist layer 22, the upper face of the pad 20 is always maintained not to be higher than the upper face of the immediate vicinity region 34 but to be normally lower than the upper face of the immediate vicinity region 34.

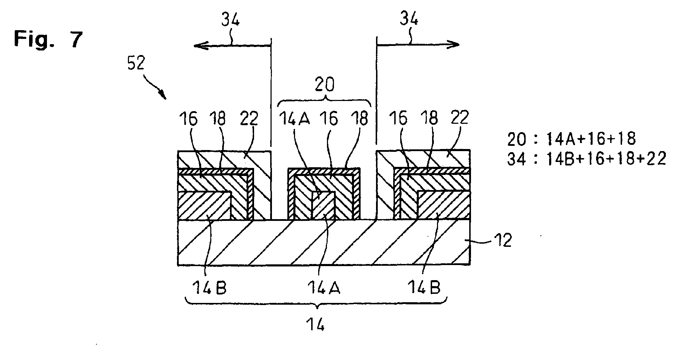

The printed wiring board 50 of the invention shown in Fig. 5A may be modified as shown by Fig.7.

According to an illustrated printed wiring board 52, the Au plating layer 18 is formed not only at the pad 20 but also at the immediate vicinity region 34. The Au plating layer 18 is very thin and therefore, even when the Au plating layer 18 is formed as in the embodiment, an influence is not effected on the high or low relationship between the pad 20 and the immediate vicinity region 34. An advantage in this case resides in that Ni plating and Au plating need not to be carried out separately but can be carried out continuously and the steps are simplified as explainedbelow. On the other hand, a drawback thereof resides in that an amount of plating Au is increased.

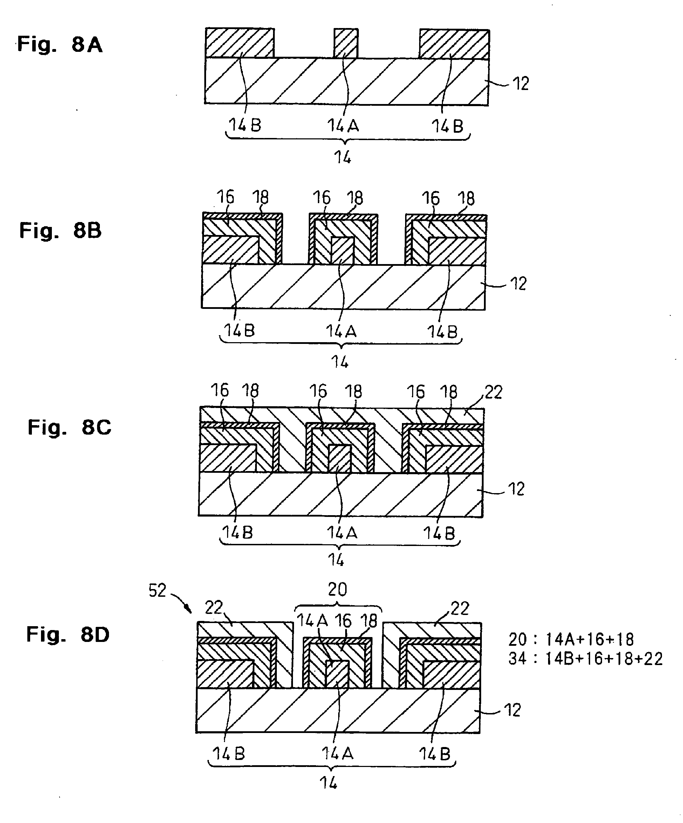

An explanation will be given of steps of fabricating the printed wiring board 52 of the invention of Fig.7 in reference to Fig.8.

First, as shown by Fig.8A, the wiring pattern 14 (14A, 14B) is formed on the insulating board 12. This is carried out similar to the case of the printed wiring board 50 of Embodiment 1 explained in reference to Fig.6A.

Next, as shown by Fig.8B, electrolytic plating is carried out, the Ni plating layer 16 as the lower layer plating layer and the Au plating layer 18 as the upper layer plating layer thereabove are formed at the wiring pattern 14 (14A, 14B).

Next, as shown by Fig.8C, the solder resist layer 22 is formed over the entire face of the board 12 by screen printing.

Next, as shown by Fig. 8D, the pad 20 constituted by laminating the portion 14A for the pad of the wiring pattern 14, the Ni plating layer 16, and the Au plating layer 18 is exposed by patterning the solder resist layer 22 by exposure and development. Thereby, the printed wiring board 52 of Fig.7 is provided.

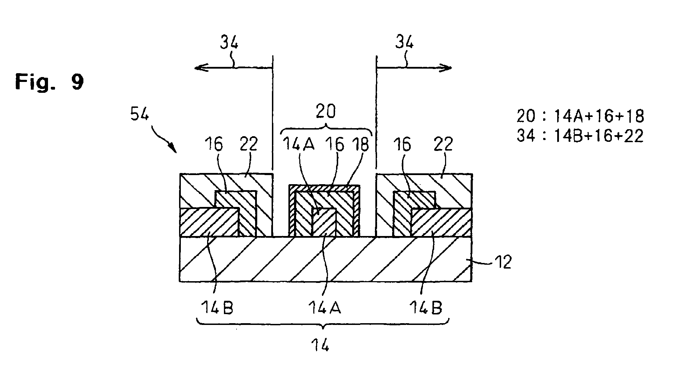

The printed wiring board 50 according to the invention shown in Fig.5A may be modified as shown by Fig.9.

According to an illustrated printed wiring board 54, the Ni plating layer 16 of the immediate vicinity region 34 is not extended over to a total of the immediate vicinity wiring 14B but is formed locally only at a vicinity of an end portion thereof proximate to the pad 20. After all, the Ni plating layer 16 is arranged at the immediate vicinity region 34 for preventing the high or low relationship between the pad 20 and the immediate vicinity region 34 from being influenced by the thickness of the Ni plating layer 16, for that purpose, even when the Ni plating layer 16 is arranged at the vicinity of the end portion of the immediate vicinity region 34 proximate to the pad 20, expected operation is achieved sufficiently. An advantage in this case resides in that an amount of plating Ni can be reduced. On the other hand, a drawback thereof resides in that steps of forming a mask and removing the mask are needed respectively before and after the Ni plating processing as explained below.

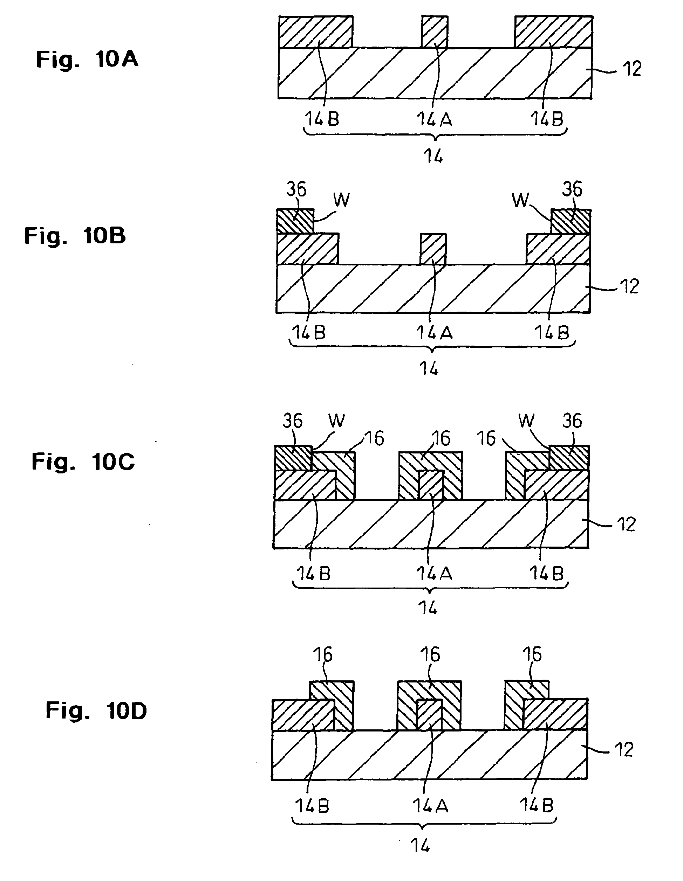

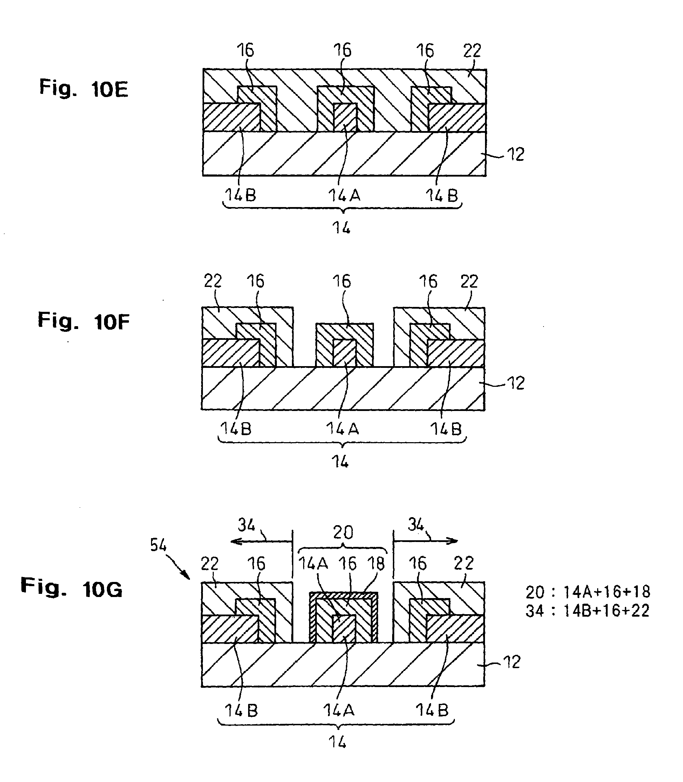

An explanation will be given of steps of fabricating the printed wiring board 54 according to the invention of Fig. 9 in reference to Fig.10.

First, as shown by Fig.10A, the wiring pattern 14 (14A, 14B) is formed on the insulating board 12. This is carried out similar to the case of the printed wiring board 50 of Embodiment 1 explained in reference to Fig.6A.

Next, as shown by Fig. 10B, a dry film mask (plating mask) 36 is formed. The mask 36 includes an opening W for exposing the portion 14A for the pad of the wiring pattern 14 and only a vicinity of an end portion of the immediate vicinity wiring 14B proximate to the portion 14A for the pad. The mask 36 is formed by a normal method, and is typically carried out by laminating the dry film and patterning by exposure and development.

Next, as shown by Fig.10C, electrolytic Ni plating is carried out and the Ni plating layer 16 as the lower layer plating layer is formed at the portion 14A for the pad of the wiring pattern 14 and the vicinity of the end portion of the immediate vicinity wiring 14B proximate to the portion 14A for the pad exposed at inside of the mask opening W.

Next, as shown by Fig. 10D, the dry film mask 36 is exfoliated to remove. Thereby, a portion of the immediate vicinity wiring 14B which is not formed with the Ni plating layer 16 is exposed.

Next, as shown by Fig.10E, the solder resist layer 22 is formed over the entire face of the board 12.

Next, as shown by Fig. 10F, the Ni plating layer 16 formed on the portion 14A for the pad of the wiring pattern 14 is exposed by patterning the solder resist layer 22 by exposure and development.

Finally, as shown by Fig.10G, electrolytic Au plating is carried out, and the Au plating layer 18 as the upper layer plating layer is formed over the entire plate (total of an upper face and side face) of the Ni plating layer 16 of the portion 14A for the wiring pattern pad exposed as described above. Thereby, the printed wiring board 54 of Fig.9 is provided.

Further, in Embodiment 3, for example, the embodiment may be modified such that at the step of Fig.10C, the Au plating layer 18 is formed on the Ni plating layer 16 of the immediate vicinity region 34 and the portion 14A for the pad.

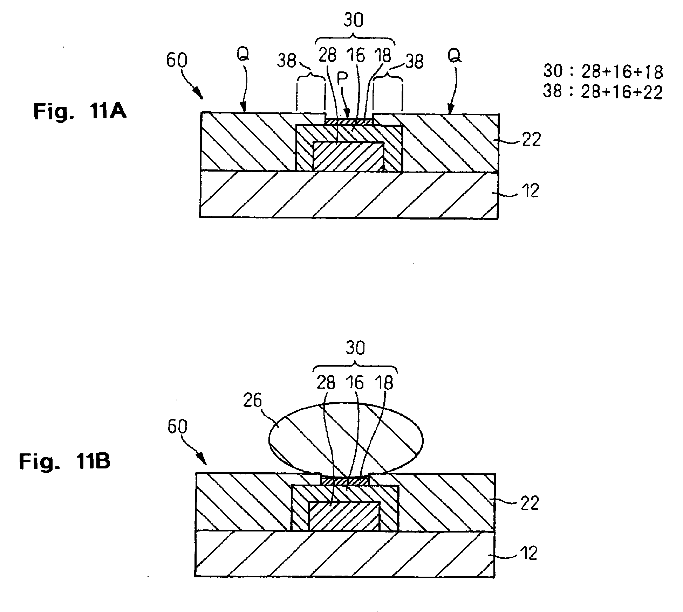

Fig.11 shows an embodiment of a printed wiring board according to the invention having a pad of an SMD type (Solder Mask Define Type).

An illustrated printed wiring board 60 is formed with the wiring pattern 28 including the conductive layer of Cu or the like on the insulating board 12 of resin or the like. At an illustrated position, the wiring pattern 28 is a portion for forming a pad.

The wiring pattern 28 is formed with the Ni plating layer 16 as the lower layer plating layer over an entire face (all of upper face and side face).

Further, the pad 30 of an SMD type (Solder Mask Define Type) is constituted by masking the peripheral edge portion of the upper face of the Ni plating layer 16 on the wiring pattern 28 and forming the Au plating layer 18 as the upper layer plating layer at inside of an opening of a center portion thereof rectified thereby. That is, the pad 30 is formed by laminating the wiring pattern 28, the Ni plating layer 16, and the Au plating layer 18. This is shown in the drawing as '30:28+16+18' as a supplementary note.

An immediate vicinity region 38 brought into contact with the pad 30 is formed by laminating the wiring pattern 28, the Ni plating layer 16 and the solder resist layer 22. This is shown in the drawing as '38:28+16+22' as a supplementary note.

Also in the case of the pad 30 of the SMD type, similar to the pad 20 of the NSMD type (Non Solder Mask Define Type) explained in Embodiments 1 through 3, operation and effect of the invention are achieved.

That is, as shown by Fig.11B, the upper face P of the pad 30 becomes lower than the upper face Q of the immediate vicinity region 38. The high or low relationship between the upper face P of the pad 30 and the upper face Q of the immediate vicinity region 38 is determined by a relationship of residues of excluding the respective thicknesses of the wiring pattern 28 and the Ni plating layer 16 common to the both portions, that is, the thicknesses of the Au plating layer 18 of the pad 30 and the solder resist layer 22 of the immediate vicinity region 38. As described above, generally, the thickness of the Au plating layer 18 is in an order of 1/10 through 1/100 of the thickness of the solder resist layer 22 and is negligible and therefore, as a result, the upper face P of the pad 30 is always maintained so as not to be higher than the upper face Q of the immediate vicinity region 38 but to be lower than the upper face Q normally.

Therefore, the peripheral edge portion of the solder ball 26 mounted on the pad 30 is held by the high immediate vicinity region 38, and the solder ball 26 can be mounted in an excellent state.

Further, the pad 30 does not jump out from the immediate vicinity region 38 and therefore, the top portion of the pad 30 is not destructed by being brought into contact therewith in handling, and the excellent solder bonding property can stably be maintained.

An explanation will be given of steps of fabricating the printed wiring board 60 of the SMD type according to the invention of Fig.11A.

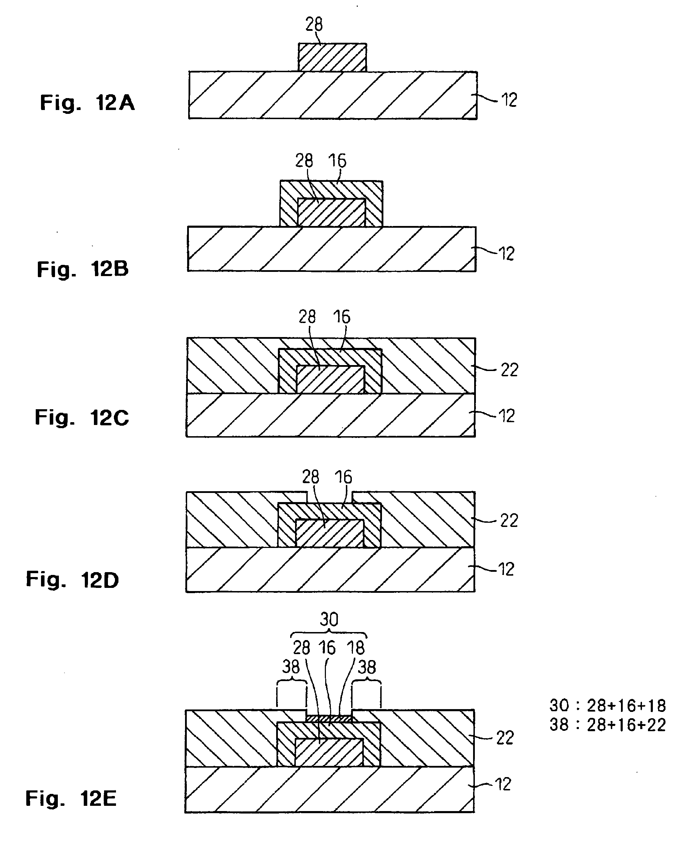

First, as shown by Fig. 12A, the wiring pattern 28 is formed on the insulating board 12 of resin or the like by patterning the conductive layer of Cu or the like. This is carried out by a procedure of machining a through hole, electroless copper plating and electrolytic copper plating, laminating, exposing, developing a dry film, etching a copper conductive layer, exfoliating the dry film by using a both faces copper coated laminated plate as one typical example by a well-known method. An illustrated portion of the wiring pattern 28 is a portion for a pad for mounting a solder ball.

Next, as shown by Fig.12B, electrolytic Ni plating is carried out, and the Ni plating layer 16 as the lower layer plating layer is formed over an entire face (total of upper face and side face) of the wiring pattern 28.

Next, as shown by Fig.12C, the solder resist layer 22 is formed over the entire face of the board 12 by screen printing.

Next, as shown by Fig.12D, only a center portion of an upper face of the Ni plating layer 16 on the wiring pattern 28 is exposed by patterning the solder resist layer 22 by exposure and development.

Next, as shown by Fig.12E, electrolytic Au plating is carried out, and the Au plating layer 18 is formed at the center portion of the upper face of the Ni plating layer 16 on the wiring pattern 28 exposed as described above. Thereby, the printed wiring board 60 of the invention having the pad 30 of the SMD type is provided.

Further, in the embodiments described with respect to Figs. 11A to 12E, the Ni plating layer 16 may be provided only at the portion for the pad of the wiring pattern 28 and the immediate vicinity region 38.

Although in the embodiments mentioned above, an explanation has been given of an example of laminating the Ni layer and the Au layer as plating layers, the invention is applicable also to a case of laminating an Ni layer, a Pd layer, an Au layer successively from a lower layer as plating layers. In this case, a middle plating layer is dealt with as a lower layer plating layer or an upper layer plating layer in view of a thickness thereof.

The pad of the wiring board and the solder ball as the connection terminal may be used as a terminal for connecting the wiring board to a mounting board, or may be used for connecting an electronic part of a semiconductor chip or the like.

According to the invention, there is provided the printed wiring board preventing the mounted solder ball from being deformed or preventing the pad before being mounted from being destructed by controlling the upper face of the pad for mounting the solder ball as the connection terminal provided at the wiring pattern so as not to be higher than the immediate vicinity region.

A mounting efficiency is promoted since the shape of the solder ball and the state of the surface of the pad are stabilized.

A fabrication efficiency is also promoted by facilitating to control the thicknesses of the pad and the immediate vicinity region.

## Claims

1. A printed wiring board (50; 52; 54; 60) comprising:
a wiring pattern (14; 28); and
a pad (20) for mounting a solder ball as a connection terminal, wherein
the wiring pattern includes the pad;
the pad is constituted by laminating a conductive layer constituting the wiring pattern, a lower layer plating layer, and an upper layer plating layer in this order;
an immediate vicinity region (34) surrounding the pad is constituted by laminating the conductive layer, at least the lower layer plating layer of the lower layer plating layer and the upper layer plating layer, and a solder resist layer in this order; and
a height of an upper face of the pad (20) does not exceed a height of an upper face of the immediate vicinity region (34) .

2. The printed wiring board according to Claim 1, wherein the conductive layer is made of Cu,
the lower layer plating layer is made of Ni, and
the upper layer plating layer is made of Au.

3. The printed wiring board according to any of Claims 1 to 2, wherein
the immediate vicinity region (34) is formed with being separated from the pad(20).

4. The printed wiring board according to any of Claims 1 to 2, wherein
the immediate vicinity region is formed with being brought into contact with the pad(20).

5. A method for fabricating the printed wiring board (50; 52; 54; 60) according to Claim 1,
the method comprising the steps of:
forming the wiring pattern (14; 28)by patterning a conductive layer on an insulating board;
forming the lower layer plating layer on the conductive layer constituting the wiring pattern;
forming the upper layer plating layer at least at a predetermined portion on the lower layer plating layer for forming the pad; and
forming the solder resist layer at other than the predetermined portion on the lower layer plating layer for forming the pad (20).

6. The printed wiring board according to any of Claims 1 to 4, wherein
the lower layer plating layer is provided only at the portion for the pad (20) of the wiring pattern and the immediate vicinity region (34).
